# EUROPEAN PATENT SPECIFICATION

(11) **EP 0 304 046 B1**
(45) Date of publication and mention of the grant of the patent: **26.01.2000**
(21) Application number: 88113392.0
(22) Date of filing: 18.08.1988
(51) Int. Cl.: G03F 7/26

(54) **A method of stripping a resist mask**
Entschichtungsverfahren für Lackmaske
Procédé pour le dépouillement de masques formant réserve

(30) Priority: 19.08.1987 JP 20398587
(43) Date of publication of application: 22.02.1989
(73) Proprietor: FUJITSU LIMITED, Kawasaki-shi, Kanagawa 211 (JP)
(72) Inventor: Fujimura, Shuzo, Edogawa-ku Tokyo, 133 (JP); Shinagawa, Keisuke, Kawasaki-shi Kanagawa, 211 (JP); Abe, Naomichi, Setagaya-ku Tokyo, 158 (JP)
(74) Representative: Seeger, Wolfgang, Dipl.-Phys.

(56) References cited:
- US-A- 4 512 868
- JOURNAL OF THE ELECTROCHEMICAL SOCIETY. vol. 129, no. 11, November 1982, MANCHESTER, NEW HAMP pages 2537 - 2541; S.Zioba et al.: "Decapsulation and Photoresist Stripping In Oxygen Microwave Plasmas"
- JOURNAL OF THE ELECTROCHEMICAL SOCIETY. vol. 124, no. 1, January 1977, MANCHESTER, NEW HAMP pages 147 - 152; J.F.Battey: "The Reduction of Photoresist Stripping Rates in an Oxygen Plasma by By-product Inhibition and Thermall Mass"
- EXTENDED ABSTRACTS. vol. 83, no. 1, May 1983, PRINCETON, NEW JERSEY page 253 C.B.Zarowin et al.: "A new high Efficiency,Sub-megahertz Exitation Frequency , Inductively coupled Plasma Generator for high Rate Downstream Photo-Resist Stripping and Isotropic Etching"
- PATENT ABSTRACTS OF JAPAN vol. 10, no. 223 (P-483)(2279) 05 August 1986, & JP-A-61 59338 (FUJITSU LTD.) 26 March 1986,
- PATENT ABSTRACTS OF JAPAN vol. 10, no. 206 (P-478)(2262) 18 July 1986, & JP-A-61 46951 (FUJITSU LTD.) 07 March 1986,
- JOURNAL OF THE ELECTROCHEMICAL SOCIETY. vol. 124, no. 1, January 1977, MANCHESTER, NEW HAMP pages 147 - 152; J.F.Battey: "The Reduction of Photoresist Stripping Rates in an Oxygen Plasma by By-product Inhibition and Thermall Mass"
- EXTENDED ABSTRACTS. vol. 83, no. 1, May 1983, PRINCETON, NEW JERSEY page 253 C.B.Zarowin et al.: "A new high Efficiency,Sub-megahertz Exitation Frequency , Inductively coupled Plasma Generator for high Rate Downstream Photo-Resist Stripping and Isotropic Etching"

## Description

### Description of the Related Art

This invention relaces to an improvement of a method of removing an organic resist on a semiconductor wafer (refered to hereinafter as ashing).

J. Electrochem. Soc. vol. 129, No. 11 (1982) 2537 says that "gaseous contaminants such as N2, H2 and water vapor are known to enhance the yield of atomic oxygen in the plasma by providing additional dissociation mechanismus for molecular oxygen" by increasing atomic oxygen relatively to molecular oxygen and ionic oxygen. This publication neither discloses nor indicates influencing of the activation energy.

It is to be noted that this known method works with ultrahigh purity oxygen microwave plasma. In order to obtain this ultrahigh purity oxygen, ore cannot simply use oxygen as commercially available but one is rather obliged to take all efforts to remove all water from it.

As well known, a mask made of an organic photoresist, etc., is necessarily employed in a photo lithography technique for fabricating semiconductor devices, etc.. After the photoresist is exposed to a light for the photo lithography, the resist must be removed. For removing this used photoresist, a plasma dry etching method, particularly a downstream ashing method, is widely employed. The downstream etching apparatus is such as disclosed by the present inventor in U.S. patent No. 4,512,868 and has been used for processing a silicon wafer, etc., where the wafer is protected from being bombarded by charged particles of the plasma.

The reaction gas used therein for ashing the organic photo resist is, for example, an oxygen gas including a CF4 (carbon tetra-fluoride) gas, etc.. However, it is not always easy to remove the used resist. This is because the resist having been affected by its exposure to a light at the exposure process and also its exposure to the plasma in a prior silicon etching process, etc., thus is hardened. Furthermore, the CF4 is apt to undesirably etch the silicon wafer. For improving the ashing rate, there is a method in which a nitrogen gas is added to the oxygen containing reaction gas to increase the number of the oxygen atoms, as reaction species. In this method containing 10 % nitrogen for example, the ashing rate is 0.3 µm/minute at 180 °C, and the increase of the ashing rate achieved with this method is still limited, because the reactive species are mainly the oxygen atoms only, and the function of the above added nitrogen gas is considered to increase only the number of the oxygen atoms as the reactive species.

### SUMMARY OF THE INVENTION

It is a general object of the invention, therefore to provide an improved method for removing an organic resist on a semiconductor wafer.

It is another object of the invention, to lower the activation energy of the reaction, accordingly lowering the reaction temperature.

It is still another object of the invention, to prevent a deterioration of the semiconductor wafer caused by a contamination with metal components contained in the resist.

It is a further object of the invention, to avoid the use of CF4 so as to avoid an undesirable etching of silicon wafer during the resist stripping, accordingly to prevent lowering the withstanding voltage of the insulation.

These objects are attained by the features of claim 1.

The addition of the water vapor into the oxygen gas increases reactive species, accordingly the ashing rate, at a wafer processing temperature as low as 150 °C. The lowered ashing temperature prevents contamination of the semiconductor wafer with metal atoms.

The above-mentioned features and advantages of the present invention, together with other objects and advantages, which will become apparent, will be more fully described hereinafter, with reference being made to the accompanying drawings which form a part hereof, wherein like numerals after to like parts throughout.

### BRIEF DESCRIPTION OF THE DRAWINGS

FIG. 1 shows effects of water addition in various reaction gases on activation energy.
FIG. 2 shows effects of water addition in an oxygen gas on ashing rate and on number of the atomic oxygen in oxygen plasma according to the present invention.
FIG. 3 shows effects of nitrogen addition in an oxygen gas on ashing rate and on number of the atomic oxygen in prior art gas plasma.
FIG. 4 shows a downstream ashing apparatus for embodying the present invention.
FIG. 5 shows another method for mixing the water vapor into the oxygen gas, for embodying the present invention.

### DESCRIPTION OF THE PREFERRED EMBODIMENTS

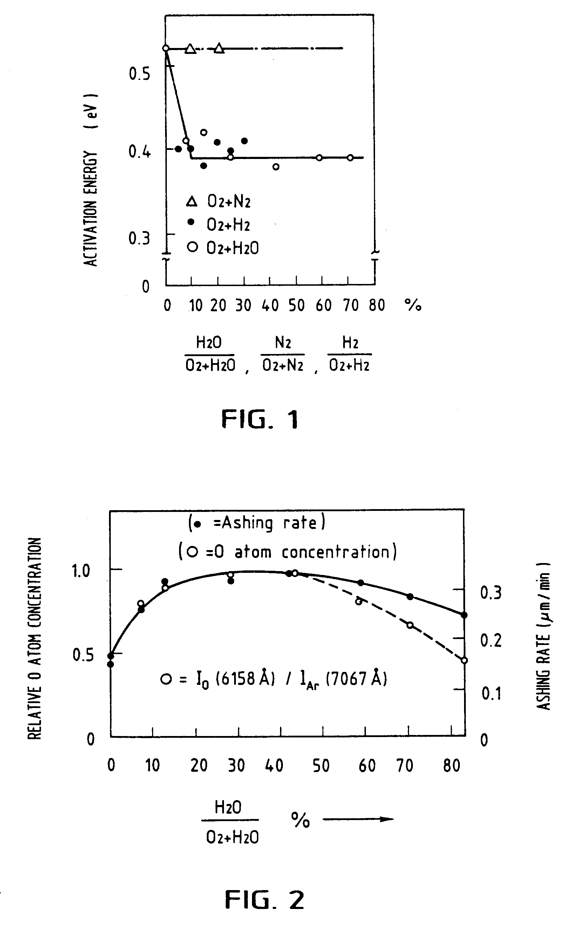

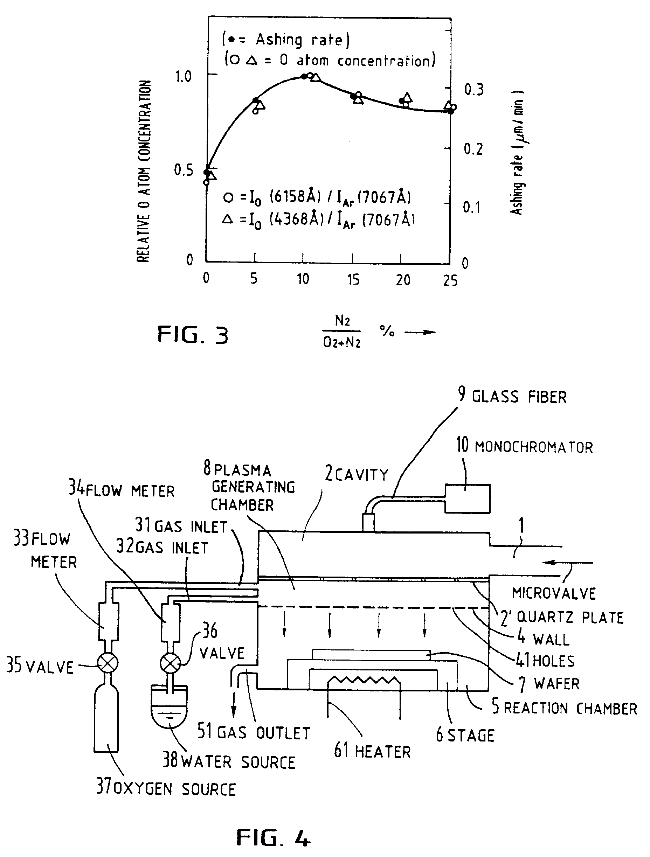

Referring FIG. 1 through FIG. 3, effects of embodying the present invention are presented. An apparatus used for obtaining the data of FIGs. 1 to 3 is schematically illustrated in FIG. 4. This apparatus is commonly used for a downstream ashing, where an microwave power, of typically 2.45 GHz, is fed through a wave guide 1 into a microwave cavity 2. A plasma generating chamber 8 is a part of the cavity 2 and is vacuum-sealed by a quartz plate 2′ which is transparent for the microwave power. Reaction gases are fed respectively from outside sources 37 and 38 of oxygen and water, via valves 35 and 36, and flow meters 33 and 34 to the plasma generating chamber 8. Accordingly, a plasma of the reaction gases is generated in the plasma generating chamber 8. On a wall 4, opposite to the quartz plate 2′, of the plasma generating chamber 8 there are provided many small holes 41 which connect the plasma generating chamber 8 to a reaction chamber 5 but shield the microwave power. The reaction gas including reactive species, such as oxygen atoms, generated in the plasma flow out of the plasma generating chamber 8 through the holes 41 into the reaction chamber 5 as shown by arrows in FIG. 4. In the reaction chamber 5, a semiconductor wafer 7 to be processed is placed on a stage 6 in a flow of the reaction gas from the holes 41, so that the reactive species reacts with the resist on the semiconductor wafer 7. Temperature of the stage 6 is raised and controlled by a heater 61 installed in the stage. The reaction gas in the reaction chamber 5 is evacuated by a pump (not shown in the figure) through an outlet 51.

As for the ashing process procedure, the wafer 7 on the stage is once heated up as high as approximately 200 °C while the chamber 5 is evacuated to approximately 0.01 Torr by the pump. Next, the inner pressure of the reaction chamber 5 is raised up to approximately 0.8 Torr and the approximately 1.5 kW microwave power is applied to the plasma generating chamber 8 so as to generate a gas plasma therein.

FIG. 1 shows effects of adding water, nitrogen or hydrogen to an oxygen gas, measured by their flow rate ratio, on activation energy. From FIG. 1 it is observed that the activation energy is lowered from approximately 0.5 eV to approximately 0.4 eV by adding hydrogen or water; however, no effect is observed by adding nitrogen. On the other hand, as well known, a speed constant k of a chemical reaction is generally given by the following formula named Arrhenius' equation:$\text{k = A exp(-E/RT)}$ where A indicates a frequency factor, E indicates an activation energy, R indicates a gas constant and T indicates the absolute temperature. Therefore, lowered value of the activation energy means a faster reaction at a certain temperature, in other word, a certain reaction speed achieved at a lower temperature.

Effects of adding water were observed by the inventors, and are shown in FIG. 2, for which a 1,000 cc/min reaction gas flow, including oxygen gas added with water vapor and 50 cc/min of argon gas are used in the apparatus shown in FIG. 4, keeping the wafer temperature at 180 °C. Percentage of the water vapor content, H₂O/(O₂+H₂O), is measured by their flow rate. The argon gas, which has no effect on the ashing reaction, is added thereto just for generating a standard light spectrum with which oxygen atoms, etc., can be quantitatively compared by a actinometry technique, which is as reported by J.W. Coburn et al. on Journal Applied Physics, vol. 51, No. 6, 1980. pp. 3134. A glass fiber 9 is installed on the wall of the cavity 2 to watch the lights generated in the plasma through the transparent quartz plate 7, which is also optically transparent. Another end of the glass fiber 9 is connected to a monochromator 10. In FIG. 2, black dots show the ashing rate scaled by the right hand side vertical axis, and white dots show the relative oxygen atom concentration scaled by the left hand side vertical axis. The relative oxygen atom concentration is measured by an actinometry method, i.e. by the ratio of the intensity of 6158 Å oxygen atom spectrum to the intensity of 7067 Å argon spectrum.

It is observed in FIG. 2 that an addition of approximately 10 % to 60 % of water vapor almost doubles the ashing rate of the case where no water is added, and the ashing rate completely relates to the amount of the oxygen atom concentration. However, at the range over 50 % of water content, the ashing rate curve slowly falls but the oxygen atom concentration curve falls faster than the ashing rate curve. This separation of the oxygen atom concentration curve from the ashing rate curve suggests that another reactive species, such as OH (hydrooxide) radical, etc., are also contributing to the ashing reaction. For comparison, an effect of the nitrogen addition to an oxygen is shown in FIG. 3, for which the total gas flow and the temperature are the same as those of FIG. 2. In FIG. 3, the black and white dots respectively show the same as in FIG. 2, and the triangle dots show a relative concentration of the oxygen atoms measured by 4368 Å oxygen atom spectrum. In either of FIG. 2 and FIG. 3, the ashing rates are almost the same. i.e. 0.3 µm/minutes, at 180 °C. However, as the effect of the lowered activation energy, the ashing rate of 40 % water-containing oxygen achieves 0.15 µm/minute is achieved at as low as 150 °C, compared with 0.1 µm/minute of an 10 % nitrogen-containing oxygen which is optimum for the fastest ashing rate, at the same temperature. These data are not shown in a figure. The lowered temperature for the ashing is significantly advantageous in that the semiconductor wafer is protected from a contamination of the metal components included in the resist material. As well known, the metal contamination deteriorates the semiconductor properties, such as heavy metals lower the minority carrier generation life time, and alkaline metals also contaminate the semiconductors.

As seen in FIG. 2, the curve of the ashing rate of the water-containing oxygen is relatively flat over the wide range of the water content, i.e. from 10 % to 80 % approximately, and is much wider than the range 5 to 15 % of the nitrogen-containing oxygen as shown in FIG. 3. This is advantageous for an easy control of an ashing operation at a production stage.

The beneficial advantage of avoiding the use of CF₄ is as follows. When a 10 % CF₄-containing oxygen gas is used for the resist etching in a downstream apparatus, the SIO₂ layer on the semiconductor wafer is also etched undesirably. The ratio of the resist ashing rate to the SIO₂ etching rate, i.e. the selectivity, is typically 300 to 500. That is to say, while 1 µm of the resist is ashed, the SIO₂ is etched 30 Å, for example. This undesirable etching of the underlaying SiO₂ layer used for a gate insulation lowers the withstanding voltage of the gate insulation, or deteriorates electrical characteristics of the semiconductor circuits. There is the same problem with polycrystalline silicon, SiN, or aluminum, as well. This problem has not been so serious in fabrication of conventional relatively low-density LSI (large scale integrated circuit), because the insulation layer is as thick as 1000 Å for 16 K bit memory devices. However, this problem is now becoming serious for fabricating the most up-to-date 1 M bit memory devices, because the insulation layer is as thin as 200 Å or less. According to the method of the present invention, there is no longer the undesirable etching problem of the SIO₂ layer, etc., at all.

As described above, in the downstream ashing apparatus the gas plasma, i.e. the electromagnetic power to generate the plasma, is confined in the plasma generating chamber by a shielding wall, only the reactive species generated in the plasma come out via many small holes on the shieding wall. The holes shield the electromagnetic waves but allow the reactive species to pass therethrough to react with the resist material. Therefore, the wafer is protected from a bombardment of the charged particles, such as ions, which may cause the deterioration of the semiconductor materials. Therefore, the reaction is purely chemical. The above-described beneficial effects of adding the water vapor in an oxygen gas can be significantly enhanced by being combined with the beneficial effect of the downstream apparatus, and is highly appreciated in the production of VLSI (very large scale integrated circuit) such as of submicron integration.

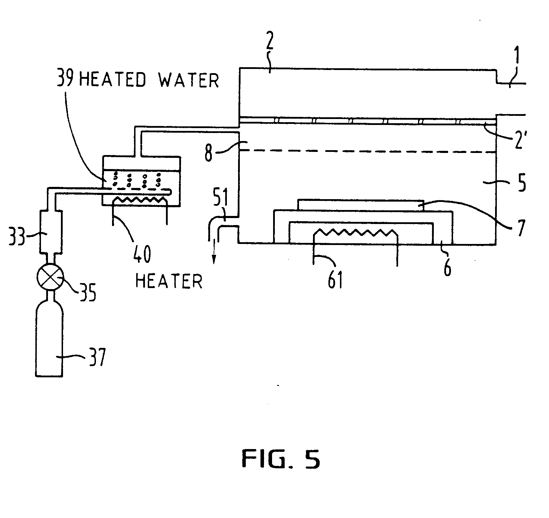

Typical and preferable methods of adding the water vapor to the oxygen gas are schematically illustrated in FIG. 4 and 5, where the same or equivalent parts are denoted with the same numbers of those of FIG. 4. In the apparatus of FIG. 4, the plasma generating chamber 8 is provided with two gas inlets 31 and 32, for introducing oxygen gas and water vapor respectively and independently from each other. Each gas is supplied to the inlet 31 and 32 from each gas source 37 and 38 through a control valves 35 and 36 and flow meters 33 and 34, respectively. If the gases are to be fed into the plasma generating chamber 8 through a single inlet, the amount of mixing the water vapor into the oxygen gas is influenced by the amount of the oxygen gas flow and the fluid resistance of the inlet pipe between the place of the water vapor mixing to the chamber 8. Therefore, in such an apparatus, it is not easy to control to add a large amount of the water vapor, such as more than 10 %, because of the relatively high gas pressure of the oxygen gas caused by the above mentioned fluid resistance. However, this problem can be solved in the apparatus shown in FIG. 4.

In the apparatus of FIG. 5, the water vapor is mixed into the oxygen flow while the oxygen gas is flowing, in other words, bubbling through a heated water 39 on the way from the gas source 37 to the chamber 8. The amount of the added water vapor is determined by the balance of the vapor pressure of the water 39 at its present temperature and the pressure of the oxygen. The water vapor pressure can be raised and controlled by the temperature of the water through which the oxygen gas is flowing. The water temperature is controlled by the heater 40. Because of relatively high vapor pressure of the heated water, a considerable amount, such as more than 10 %, of the water vapor can be easily mixed into the oxygen gas, under precise control.

As shown in FIG. 1 an addition of a hydrogen gas into an oxygen gas exhibits a good effect to lower the activation energy. However, as is well known, the mixture of more than 3 % hydrogen gas in the oxygen gas will cause an explosion. Therefore, the hydrogen gas can not be industrially employed as the plasma reaction gas.

The many features and advantages of the invention are apparent from the detailed specification and thus, it is intended by the appended claims to cover all such features and advantages of the method. Further, since numerous modifications and changes may readily occur to those skilled in the art, it is not desired to limit the invention to the exact construction and operation shown and described, and accordingly, all suitable modifications and equivalents may be resorted to, falling within the scope of the invention.

## Claims

1. A method for removing an organic resist on a semiconductor wafer, the method employing a downstream ashing apparatus that comprises a plasma generating chamber, a reaction chamber and a shield for confining an electromagnetic power within the plasma generating chamber but allowing electrically neutral reactive species generated in plasma to flow into the reactive chamber the method comprising the steps of:
(a) placing the semiconductor wafer in the reaction chamber;
(b) introducing an oxygen gas and an electromagnetic power into the plasma generating chamber so as to generate a gas plasma therein, and
(c) introducing the electrically neutral reactive species toward the semiconductor wafer,
characterized in that
the electrically neutral reactive species react with the organic resist on the semiconductor wafer while the semiconductor wafer is protected from being bombarded by electrically charged particles generated in the plasma, and
that water vapor is introduced to lower an activation energy of the reaction with the organic resist.

2. A method for removing an organic resist on a semiconductor wafer according to claim 1, wherein the oxygen gas and water vapor are introduced into the plasma generating chamber from outside sources through valves and flow meters independently and respectively to each other.

3. A method for removing an organic resist on a semiconductor wafer according to claim 1 or 2, wherein the electrically neutral reactive species flow out of the plasma generating chamber through holes in a wall of the plasma generating chamber to be introduced to the semiconductor wafer in the reaction chamber.

4. A method for removing an organic resist on a semiconductor wafer according to any of claims 1 to 3, wherein the semiconductor wafer in the reaction chamber is placed so that only the electrically neutral reactive species flowing through holes of the wall react with the organic resist on the semiconductor wafer without exposing the semiconductor wafer to the electromagnetic power and the electrically charged particles generated in the plasma generating chamber.

5. A method for removing an organic resist on a semiconductor wafer according to any of claims 1, 2 and 4 wherein the electrically neutral species are an oxygen atom and an OH (hydrooxide) radical.

6. A method for removing an organic resist on a semiconductor wafer according to any preceding claim, wherein a relative molecular weight of water vapor is selected so that an activation energy of ashing the organic resist is kept less than or equal to 0,42 eV.

7. A method for removing an organic resist on a semiconductor wafer according to claim 6, wherein the relative molecular weight of water vapor is selected to be higher than or equal to 10%.

8. A method for removing an organic resist on a semiconductor wafer according to any of claims 1 to 7, wherein a relative molecular weight of water vapor is selected so that the ashing rate of the organic resist achieves 0,3 µm per minute at a temperature of 180°C and 0,15 µm per minute at a temperature of as low as 150°C.

9. A method for removing an organic resist on a semiconductor wafer according to 8, wherein the relative molecular weight of water vapor is selected to be 10% ∼ 80%.

10. A method for removing an organic resist on a semiconductor wafer according to any preceding claim, wherein the semiconductor wafer has an underlying insulating layer as thin as 20 nm or less for the organic resist.

11. A method for removing an organic resist on a semiconductor wafer according to claim 10, wherein the underlying insulating layer is an SiO₂ layer.

12. A method for removing an organic resist on a semiconductor wafer according to claim 10 or 11, wherein the underlying insulating layer is the gate insulating layer of submicron devices for very large scale integrated circuits.

13. A method for removing an organic resist on a semiconductor wafer according to any preceding claim, wherein the removing organic resist is a purely chemical reaction which is carried out so as to avoid an undesirable etching problem of underlying layers of SiO₂ polycristalline silicon, SiN, or aluminium.

14. A method for removing an organic resist on a semiconductor wafer according to any preceding claim, wherein an ashing temperature is lower than 150°C for an ashing rate of smaller than 0.15 µm per minute.

## Patentansprüche

1. Verfahren zum Entfernen eines organischen Resists auf einem Halbleiterwafer, bei welchem verfahren eine Abwärtsstromveraschungsvorrichtung verwendet wird, mit einer Plasmaerzeugungskammer, einer Reaktionskammer und einem Schirm zum Einschließen einer elektromagnetischen Energie in der Plasmaerzeugungskammer, aber zum Ermöglichen des Fließens von elektrisch neutralen reaktiven Arten, die in dem Plasma erzeugt werden, in die Reaktionskammer, welches Verfahren die folgenden Schritte umfaßt:
(a) Anordnen des Halbleiterwafers in der Reaktionskammer;
(b) Leiten eines Sauerstoffgases und einer elektromagnetischen Energie in die Plasmaerzeugungskammer, um in ihr ein Gasplasma zu erzeugen, und
(c) Leiten der elektrisch neutralen reaktiven Arten hin zu dem Halbleiterwafer,
dadurch gekennzeichnet, daß
die elektrisch neutralen reaktiven Arten mit dem organischen Resist auf dem Halbleiterwafer reagieren, während der Halbleiterwafer vor dem Beschuß mit elektrisch geladenen Teilchen geschützt wird, die in dem Plasma erzeugt werden, und daß
Wasserdampf eingeleitet wird, um eine Aktivierungsenergie der Reaktion mit dem organischen Resist zu verringern.

2. Verfahren zum Entfernen eines organischen Resists auf einem Halbleiterwafer nach Anspruch 1, bei dem das Sauerstoffgas und der Wasserdampf von äußeren Quellen durch jeweilige Ventile und Flußmesser unabhängig voneinander in die Plasmaerzeugungskammer eigeleitet werden.

3. Verfahren zum Entfernen eines organischen Resists auf einem Halbleiterwafer nach Anspruch 1 oder 2, bei dem die elektrisch neutralen reaktiven Arten durch Löcher in einer Wand der Plasmaerzeugungskammer aus der Plasmaerzeugungskammer herausfließen, um zu dem Halbleiterwafer in der Reaktionskammer eingeleitet zu werden.

4. Verfahren zum Entfernen eines organischen Resists auf einem Halbleiterwafer nach irgendeinem der Ansprüche 1 bis 3, bei dem der Halbleiterwafer in der Reaktionskammer so angeordnet wird, daß nur die elektrisch neutralen reaktiven Arten, die durch Löcher der Wand hindurchfließen, mit dem organischen Resist auf dem Halbleiterwafer reagieren, ohne den Halbleiterwafer der elektromagnetischen Energie und den elektrisch geladenen Teilchen auszusetzen, die in der Plasmaerzeugungskammer erzeugt werden.

5. Verfahren zum Entfernen eines organischen Resists auf einem Halbleiterwafer nach irgendeinem der Ansprüche 1, 2 und 4, bei dem die elektrisch neutralen Arten ein Sauerstoffatom und ein OH-(Hydroxid)-Radikal sind.

6. Verfahren zum Entfernen eines organischen Resists auf einem Halbleiterwafer nach irgendeinem vorhergehenden Anspruch, bei dem ein relatives Molekulargewicht von Wasserdampf so selektiert wird, daß eine Aktivierungsenergie beim Veraschen des organischen Resists unter oder auf 0,42 eV gehalten wird.

7. Verfahren zum Entfernen eines organischen Resists auf einem Halbleiterwafer nach Anspruch 6, bei dem das relative Molekulargewicht von Wasserdampf selektiert wird, um höher als oder gleich 10 % zu sein.

8. Verfahren zum Entfernen eines organischen Resists auf einem Halbleiterwafer nach irgendeinem der Ansprüche 1 bis 7, bei dem ein relatives Molekulargewicht von Wasserdampf so selektiert wird, daß die Veraschungsrate des organischen Resists 0,3 µm pro Minute bei einer Temperatur von 180 °C und 0,15 µm pro Minute bei einer Temperatur von nur 150 °C erreicht.

9. Verfahren zum Entfernen eines organischen Resists auf einem Halbleiterwafer nach Anspruch 8, bei dem das relative Molekulargewicht von Wasserdampf selektiert wird, um 10 % ∼ 80 % zu betragen.

10. Verfahren zum Entfernen eines organischen Resists auf einem Halbleiterwafer nach irgendeinem vorhergehenden Anspruch, bei dem der Halbleiterwafer eine darunterliegende Isolierschicht hinsichtlich des organischen Resists hat, die 20 nm oder dünner ist.

11. Verfahren zum Entfernen eines organischen Resists auf einem Halbleiterwafer nach Anspruch 10, bei dem die darunterliegende Isolierschicht eine SiO₂-Schicht ist.

12. Verfahren zum Entfernen eines organischen Resists auf einem Halbleiterwafer nach Anspruch 10 oder 11, bei dem die darunterliegende Isolierschicht die Gateisolierschicht von Submikrometervorrichtungen für höchstintegrierte Schaltungen ist.

13. Verfahren zum Entfernen eines organischen Resists auf einem Halbleiterwafer nach irgendeinem vorhergehenden Anspruch, bei dem das Entfernen von organischem Resist eine rein chemische Reaktion ist, die ausgeführt wird, um ein unerwünschtes Ätzproblem von darunterliegenden Schichten aus SiO₂, polykristallinem Silizium, SiN oder Aluminium zu vermeiden.

14. Verfahren zum Entfernen eines organischen Resists auf einem Halbleiterwafer nach irgendeinem vorhergehenden Anspruch, bei dem eine Veraschungstemperatur für eine Veraschungsrate von unter 0,15 µm pro Minute niedriger als 150 °C ist.

## Revendications

1. Procédé d'enlèvement d'un matériau organique de réserve présent sur une tranche semi-conductrice, le procédé mettant en oeuvre un appareil d'incinération aval qui comporte une chambre génératrice de plasma, une chambre de réaction et un organe de protection destiné à confiner de l'énergie électromagnétique à l'intérieur de la chambre génératrice de plasma, tout en permettant à une espèce réactive électriquement neutre créée dans le plasma de s'écouler dans la chambre de réaction, le procédé comprenant les étapes suivantes :
(a) la disposition de la tranche semi-conductrice dans la chambre de réaction,
(b) l'introduction d'oxygène gazeux et d'énergie électromagnétique dans la chambre génératrice de plasma pour la création d'un plasma d'un gaz dans cette chambre, et
(c) l'introduction de l'espèce réactive électriquement neutre vers la tranche semi-conductrice,
caractérisé en ce que :
l'espèce réactive électriquement neutre réagit avec le matériau organique de réserve sur la tranche semi-conductrice pendant que la tranche semi-conductrice est protégée contre le bombardement par des particules électriquement chargées créées dans le plasma, et
la vapeur d'eau est introduite afin qu'elle abaisse l'énergie d'activation de la réaction avec le matériau organique de réserve.

2. Procédé d'enlèvement d'un matériau organique de réserve présent sur une tranche semi-conductrice selon la revendication 1, dans lequel l'oxygène gazeux et la vapeur d'eau sont introduits dans la chambre génératrice de plasma par des sources externes par l'intermédiaire de robinets et de débitmètres indépendamment l'un de l'autre et respectivement.

3. Procédé d'enlèvement d'un matériau organique de réserve présent sur une tranche semi-conductrice selon la revendication 1 ou 2, dans lequel l'espèce réactive électriquement neutre s'écoule en dehors de la chambre génératrice de plasma par des trous formés dans une paroi de la chambre génératrice de plasma pour être introduite vers la tranche semi-conductrice placée dans la chambre de réaction.

4. Procédé d'enlèvement d'un matériau organique de réserve présent sur une tranche semi-conductrice selon l'une quelconque des revendications 1 à 3, dans lequel la tranche semi-conductrice présente dans la chambre de réaction est disposée afin que seule l'espèce réactive électriquement neutre circulant par les trous de la paroi réagisse avec le matériau organique de réserve présent sur la tranche semi-conductrice sans exposition de la tranche semi-conductrice à l'énergie électromagnétique et aux particules électriquement chargées créées dans la chambre génératrice de plasma.

5. Procédé d'enlèvement d'un matériau organique de réserve présent sur une tranche semi-conductrice selon l'une quelconque des revendications 1, 2 et 4, dans lequel l'espèce électriquement neutre est un atome d'oxygène et un radical OH (hydroxyde).

6. Procédé d'enlèvement d'un matériau organique de réserve présent sur une tranche semi-conductrice selon l'une quelconque des revendications précédentes, dans lequel la masse moléculaire relative de la vapeur d'eau est sélectionnée afin que l'énergie d'activation de l'incinération du matériau organique de réserve reste inférieure ou égale à 0,42 eV.

7. Procédé d'enlèvement d'un matériau organique de réserve présent sur une tranche semi-conductrice selon la revendication 6, dans lequel la masse moléculaire relative de la vapeur d'eau est sélectionnée afin qu'elle soit supérieure ou égale à 10 %.

8. Procédé d'enlèvement d'un matériau organique de réserve présent sur une tranche semi-conductrice selon l'une quelconque des revendications 1 à 7, dans lequel la masse moléculaire relative de la vapeur d'eau est sélectionnée afin que la vitesse d'incinération du matériau organique de réserve atteigne 0,3 µm/min à une température de 180 °C et 0,15 µm/min à une température aussi faible que 150 °C.

9. Procédé d'enlèvement d'un matériau organique de réserve présent sur une tranche semi-conductrice selon la revendication 8, dans lequel la masse moléculaire relative de la vapeur d'eau est sélectionnée entre 10 et 80 %.

10. Procédé d'enlèvement d'un matériau organique de réserve présent sur une tranche semi-conductrice selon l'une quelconque des revendications précédentes, dans lequel la tranche semi-conductrice a une couche isolante sous-jacente d'épaisseur inférieure ou égale à 20 nm sous le matériau organique de réserve.

11. Procédé d'enlèvement d'un matériau organique de réserve présent sur une tranche semi-conductrice selon la revendication 10, dans lequel la couche isolante sous-jacente est une couche de SiO₂.

12. Procédé d'enlèvement d'un matériau organique de réserve présent sur une tranche semi-conductrice selon la revendication 10 ou 11, dans lequel la couche isolante sous-jacente est la couche d'isolant de grille de dispositifs de circuits intégrés à très grande échelle de dimensions inférieures au micron.

13. Procédé d'enlèvement d'un matériau organique de réserve présent sur une tranche semi-conductrice selon l'une quelconque des revendications précédentes, dans lequel l'enlèvement du matériau organique de réserve est une réaction purement chimique exécutée afin qu'un problème d'attaque indésirable des couches sous-jacentes de SiO₂, de silicium polycristallin, de SiN ou d'aluminium soit évité.

14. Procédé d'enlèvement d'un matériau organique de réserve présent sur une tranche semi-conductrice selon l'une quelconque des revendications précédentes, dans lequel la température d'incinération est inférieure à 150 °C pour une vitesse d'incinération inférieure à 0,15 µm/min.
